# EUROPÄISCHE PATENTSCHRIFT

(11) **EP 3 354 990 B1**
(45) Veröffentlichungstag und Bekanntmachung des Hinweises auf die Patenterteilung: **30.09.2020**
(21) Anmeldenummer: 18151410.0
(22) Anmeldetag: 12.01.2018
(51) Int. Cl.: F24C 7/08, H03K 17/96

(54) **BEDIENELEMENT FÜR EIN HAUSHALTSGERÄT MIT EINEM 2K-KUNSTSTOFFGEHÄUSE ODER EINEM 1K-KUNSTSTOFFGEHÄUSE SOWIE BEDIENVORRICHTUNG UND HAUSHALTSGERÄT**
OPERATING ELEMENT FOR A DOMESTIC APPLIANCE WITH A 2K PLASTIC HOUSING OR A 1K PLASTIC HOUSING AND OPERATING DEVICE AND DOMESTIC APPLIANCE
DISPOSITIF DE COMMANDE POUR UN APPAREIL ÉLECTROMÉNAGER POURVU D'UN BOÎTIER EN MATIÈRE PLASTIQUE 2K OU D'UN BOÎTIER EN MATIÈRE PLASTIQUE 1K AINSI QUE DISPOSITIF DE COMMANDE ET APPAREIL ÉLECTROMÉNAGER

(30) Priorität: 30.01.2017 DE 102017201382
(43) Veröffentlichungstag der Anmeldung: 01.08.2018
(73) Patentinhaber: BSH Hausgeräte GmbH, 81739 München (DE)
(72) Erfinder: Bosold, Karl-Richard, 83368 St. Georgen (DE); Forster, Florian, 83346 Bergen (DE); Grätz, Franz, 83374 Traunwalchen (DE); Huber, Johann, 83334 Inzell (DE); Marbach, Andreas, 83374 Traunwalchen (DE); Wurnitsch, Ernst, 6382 Kirchdorf in Tirol (AT)

(56) Entgegenhaltungen:
- EP-A1- 3 059 862
- EP-A2- 2 827 497
- DE-A1-102006 062 393
- DE-A1-102013 213 034
- DE-A1-102013 227 020

## Beschreibung

Die Erfindung betrifft ein Bedienelement für ein Haushaltsgerät. Das Bedienelement weist eine kapazitive Sensortaste auf. Diese kapazitive Sensortaste weist ein Gehäuse auf, das zumindest bereichsweise aus einem elektrisch leitfähigen Kunststoff ausgebildet ist. Des Weiteren betrifft die Erfindung auch eine Bedienvorrichtung mit einem derartigen Bedienelement als auch ein Haushaltsgerät.

Kapazitive Sensortasten sind aus dem Stand der Technik bekannt. Beispielsweise offenbart die DE 10 2012 010 321 A1 eine derartige. Die dortige kapazitive Sensortaste ist Bestandteil einer Bedieneinrichtung eines Kochfelds. Die kapazitive Sensortaste mit ihrem Gehäuse ist dort insbesondere als 3K-Spritzbauteil ausgebildet.

Derartige Bedienelemente sind in der Herstellung sehr aufwendig und auch bei komplexeren Formgebungen des Gehäuses ist die Ausgestaltung der jeweiligen Teilbereiche der verschiedenen Kunststoffe dieses 3K-Spritzbauteils schwierig.

Die DE 10 2013 213 034 A1 beschreibt ein Bedienelement mit einem Bedienelementgehäuse und mit einem von dem Bedienelementgehäuse umgebenen Lichtleitkörper.

Die EP 2 827 497 A2 beschreibt eine Bedieneinrichtung für ein Elektrogerät, welche mehrere Anzeigeelemente in Form von Lichtleitkanälen mit Leuchtmitteln, kapazitive Sensorelemente und eine lichtdurchlässige Bedienfläche darüber aufweist.

Es ist Aufgabe der vorliegenden Erfindung, ein Bedienelement als kapazitive Sensortaste zu schaffen, bei welchem das Gehäuse einfacher herstellbar ist und dennoch bezüglich der kapazitiven Funktionalität uneingeschränkt wirkend ist.

Diese Aufgabe wird durch ein Bedienelement, eine Bedienvorrichtung und ein Haushaltsgerät gemäß den unabhängigen Ansprüchen gelöst.

Ein Aspekt der Erfindung betrifft ein Bedienelement für ein Haushaltsgerät, wobei das Bedienelement als kapazitive Sensortaste ausgebildet ist. Diese kapazitive Sensortaste weist ein Gehäuse auf, das zumindest bereichsweise aus einem elektrisch leitfähigen Kunststoff ausgebildet ist. Das Gehäuse ist als 2K-Kunststoffgehäuse oder als 1K-Kunststoffgehäuse ausgebildet. Dies bedeutet, dass das Gehäuse als Spritzbauteil ausgebildet ist und maximal aus zwei verschiedenen Kunststoffen gespritzt ist. Eine derartige Ausgestaltung ist die Herstellbarkeit dieses Bedienelements vereinfacht und dennoch die kapazitive Wirkfunktion uneingeschränkt aufrechterhalten. Durch eine derartige Ausgestaltung eines Bedienelements kann somit die Fertigung auch schneller erfolgen und darüber hinaus ist das Bedienelement dann auch kostengünstiger.

Es ist vorgesehen, dass das Gehäuse einen Bediengehäusebereich zum Bedienen mit einem Finger aufweist, und einen gegenständlich eigenen Anzeigegehäusebereich zum optischen Anzeigen von Lichtinformationen aufweist, wobei der Bediengehäusebereich und der Anzeigegehäusebereich einstückig ausgebildet sind beziehungsweise hergestellt sind. Durch diese Ausgestaltung sind somit zwei auch gegenständlich andere und somit separierte große Bereiche des einstückigen Gehäuses realisiert, denen unterschiedliche Funktionen zugeordnet sind. Durch diese Ausgestaltung wird bei einem Berühren des Gehäuses die dann zugleich erzeugte Anzeige der optischen Lichtinformation nicht verdeckt, wie es bei Ausführungen der Fall ist, bei denen der Bediengehäusebereich und der Anzeigegehäusebereich die gleichen Bereiche sind.

Durch diese Ausgestaltung lässt sich ein zuverlässiges Betätigen und gleichzeitiges Wahrnehmen von Lichtinformationen realisieren. Darüber hinaus können die einzelnen Gehäusebereiche dann auch individuell gefertigt werden, insbesondere im Hinblick auf ihre Wanddicken. Insbesondere der Anzeigegehäusebereich kann dann beispielsweise auch mit dünneren Wänden und/oder kleiner ausgebildet werden. Dadurch kann auch Material eingespart werden, wodurch auch eine Gewichtsreduzierung erzielt ist.

Des Weiteren ist vorgesehen, dass der Bediengehäusebereich und der Anzeigegehäusebereich nebeneinander und direkt aneinander angrenzend ausgebildet sind. Durch diese überlappungsfreie Ausgestaltung werden die oben genannten Vorteile nochmals verbessert und dennoch ein kompaktes Gehäuse geschaffen. Darüber hinaus ist durch diese Ausgestaltung auch eine gewisse mechanische Stabilisierung der einzelnen Gehäusebereiche gegenseitig erreicht.

Des Weiteren ist vorgesehen, dass eine Gehäusewand Bestandteil des Bediengehäusebereichs und des Anzeigegehäusebereichs ist und diese Gehäusebereiche durch diese Gehäusewand voneinander räumlich getrennt sind. Die jeweils durch die Gehäusebereiche umschlossenen Volumen sind somit getrennt voneinander und indem diese eine Gehäusewand funktionell beiden Gehäusebereichen zugeordnet ist, kann auch hier wiederum Material eingespart werden.

Vorzugsweise ist vorgesehen, dass das Gehäuse nicht elastisch ausgebildet ist. Durch eine derartige Ausgestaltung ist dann auch die positionsgenaue Montage auf einer Leiterplatte einer Bedienvorrichtung einfach ermöglicht.

Vorzugsweise weist das Gehäuse Kontaktstifte auf, die zum Hindurchführen in Durchkontaktierungen in einer Leiterplatte ausgebildet sind, wobei diese Kontaktstifte aus dem elektrisch leitfähigen Kunststoff ausgebildet sind. Für eine derartige Ausgestaltung wird dann in multifunktioneller Weise die mechanisch stabile Befestigung an der Leiterplatte einerseits und die elektrische Verbindung andererseits realisiert.

Vorzugsweise ist die den Bediengehäusebereich und den Anzeigegehäusebereich trennende Gehäusewand des Gehäuses auf der Leiterplatte aufsitzend angeordnet, wobei die Leiterplatte Bestandteil der Bedienvorrichtung ist.

Insbesondere ist vorgesehen, dass bei einer Ausgestaltung als 2K-Kunststoffhäuse das Gehäuse bereichsweise aus dem elektrisch leitfähigen Kunststoff und bereichsweise aus einem elektrisch nicht leitfähigen Kunststoff ausgebildet ist. Eine elektrische Leitfähigkeit, die beispielsweise durch Zugabe von Graphitpartikeln oder Rußpartikeln oder Metallpulver erreicht ist, ist somit hier nur lokal ausgebildet.

Das Bedienelement kann ohne Beleuchtung beziehungsweise Leuchtsymbole ausgebildet sein und somit lediglich nur bezüglich der elektrischen Funktionalität als kapazitive Sensortaste ausgebildet sein.

Bei einer alternativen Ausgestaltung kann jedoch auch zumindest eine Lichtquelle diesem Bedienelement zugeordnet sein, mit welcher dann optische Anzeigen, insbesondere auch Lichtinformationen erfolgen können, die beispielsweise eine Bedieneinstellung, die durch Berühren der kapazitiven Sensortaste einhergeht, darstellen.

Des Weiteren betrifft die Erfindung auch eine Bedienvorrichtung für ein Haushaltsgerät, welches ein Bedienelement gemäß dem oben genannten Aspekt oder einer vorteilhaften Ausgestaltung davon aufweist.

Des Weiteren betrifft die Erfindung auch ein Haushaltsgerät, insbesondere ein Gargerät, welches eine entsprechende Bedienvorrichtung aufweist. Das Gargerät kann beispielsweise ein Kochfeld sein.

Das Gehäuse der kapazitiven Sensortaste kann geometrisch vielfältigst ausgebildet sein. Sowohl in der Geometrie und somit der spezifischen Formgebung als auch bezüglich der Ausmaße, und somit der Höhe, der Breite und der Tiefe, können unterschiedlichste Spezifikationen realisiert sein. Das Gehäuse kann viereckig sein oder auch fünfeckig, sechseckig oder darüber hinausgehend eine noch höhere Eckenzahl aufweisen. Es kann an der der Leiterplatte abgewandten Oberseite geschlossen sein oder auch geöffnet sein. In geschlossenem Zustand ist somit eine Deckenwand ausgebildet, die vollkommen geschlossen sein kann. Die Deckenwand kann andererseits jedoch auch lokal individuelle Durchbrechungen aufweisen, die wiederum individuelle Formgebungen, beispielsweise eine eckenfreie Kontur oder aber auch eine eckige Kontur, aufweisen können. Ebenso ist es möglich, dass diese Deckenwand sehr filigran ausgebildet ist und beispielsweise nur als umlaufender Rahmen gestaltet ist. Auch dieser Rahmen kann darin viereckig, fünfeckig, sechseckig oder darüber hinausgehend mit noch mehreren Ecken ausgebildet sein. Ebenso ist auch hier eine eckenfreie Form, beispielsweise ein Kreis oder ein Oval möglich.

Ein Ausführungsbeispiel der Erfindung wird nachfolgend anhand schematischer Zeichnungen näher erläutert. Es zeigen:
- Fig. 1: eine vereinfachte Frontansicht eines Ausführungsbeispiels eines erfindungsgemäßen Haushaltsgeräts;
- Fig. 2: eine perspektivische Darstellung eines weiteren Ausführungsbeispiels eines erfindungsgemäßen Haushaltsgeräts;
- Fig. 3: eine Schnittdarstellung durch ein Ausführungsbeispiel einer Bedienvorrichtung;
- Fig. 4: eine Schnittdarstellung durch ein weiteres Ausführungsbeispiel einer Bedienvorrichtung;
- Fig. 5a bis 5d: perspektivische Darstellungen von verschiedenen Ausführungsbeispielen von Gehäusen eines Ausführungsbeispiels eines Bedienelements, wie es bei einer Bedienvorrichtung für ein Haushaltsgerät verbaut sein kann;
- Fig. 6: eine Schnittdarstellung eines weiteren Ausführungsbeispiels einer Bedienvorrichtung;
- Fig. 7a und 7b: perspektive Darstellungen zu der Bedienvorrichtung gemäß Fig. 6;
- Fig. 8: eine Schnittdarstellung für ein weiteres Ausführungsbeispiel einer Bedienvorrichtung;
- Fig. 9: eine perspektivische Darstellung des Ausführungsbeispiels der Bedienvorrichtung gemäß Fig. 8;
- Fig. 10: eine weitere Schnittdarstellung durch ein Ausführungsbeispiel einer erfindungsgemäßen Bedienvorrichtung;
- Fig. 11: eine perspektivische Darstellung eines Ausführungsbeispiels der Bedienvorrichtung gemäß Fig. 10;
- Fig. 12: eine weitere Schnittdarstellung durch ein weiteres Ausführungsbeispiel einer Bedienvorrichtung; und
- Fig. 13: eine perspektivische Darstellung der Bedienvorrichtung gemäß Fig. 12.

In den Figuren werden gleiche oder funktionsgleiche Elemente mit den gleichen Bezugszeichen versehen.

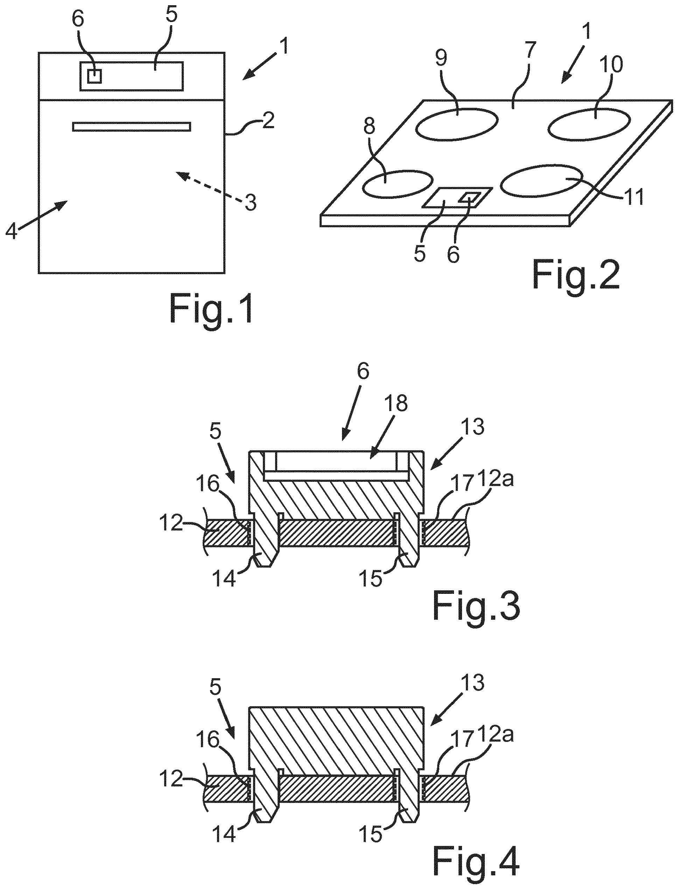

In Fig. 1 ist in einer vereinfachten Frontansicht ein Haushaltsgerät 1 gezeigt, welches als Gargerät ausgebildet ist, beispielsweise als Backofen ausgebildet ist. Dieses Haushaltsgerät 1 weist ein Gehäuse auf, in dem ein Garraum 3 ausgebildet ist, der durch Wände einer Muffel begrenzt ist. Frontseitig ist der Garraum 3 durch eine Tür 4 verschließbar, die hier in geschlossenem Zustand gezeigt ist. Das Haushaltsgerät 1 weist darüber hinaus eine Bedienvorrichtung 5 auf, die zumindest ein Bedienelement 6 aufweist, welches als kapazitive Sensortaste ausgebildet ist.

In Fig. 2 ist ein weiteres Ausführungsbeispiel eines Haushaltsgeräts 1 gezeigt, welches als Gargerät ausgebildet ist und hier als Kochfeld ausgebildet ist. Dieses Haushaltsgerät 1 gemäß Fig. 2 weist eine Kochfeldplatte 7 auf, auf der in Anzahl und Größe lediglich beispielhaft und nicht abschließend zu verstehen mehrere Kochzonen 8, 9, 10 und 11 ausgebildet sind. Dieses Haushaltsgerät 1 weist ebenfalls eine Bedienvorrichtung 5 auf, welche ebenfalls zumindest ein Bedienelement 6 aufweist, das eine kapazitive Sensortaste ist.

In Fig. 3 ist in einer Vertikalschnittdarstellung ein Ausführungsbeispiel einer Bedienvorrichtung 5 gezeigt, wobei hier Teilelemente dargestellt sind. Die Bedienvorrichtung 5 weist eine Leiterplatte 12 auf, auf welcher das Bedienelement 6 in Form der kapazitiven Sensortaste angeordnet ist. Diese kapazitive Sensortaste weist ein Gehäuse 13 auf, welches in der gezeigten Ausführung als 1K-Kunststoffgehäuse ausgebildet ist. Dieses Gehäuse 13 weist in einer einstückigen Ausgestaltung auch Kontaktstifte 14 und 15 auf, welche durch Durchkontaktierungen 16 und 17 der Leiterplatte 12 hindurchgesteckt sind und mit entsprechenden elektrischen Leitungen elektrisch verbunden sind. Das Gehäuse 13 ist aus einem elektrisch leitfähigen Kunststoff ausgebildet und in sich starr, sodass das Gehäuse 13 nicht elastisch ausgebildet ist. Das hier gezeigte Bedienelement 6 in Form der kapazitiven Sensortaste ist ohne Beleuchtung und somit auch ohne Leuchtsymbole ausgebildet.

In Fig. 4 ist in einer entsprechenden Vertikalschnittdarstellung ein weiteres Ausführungsbeispiel einer Bedienvorrichtung 5 gezeigt. Im Unterschied zur Darstellung gemäß Fig. 3 ist das Gehäuse 13 nicht mit einer nach obenhin offenen Mulde 18 ausgebildet, wie sie in Fig. 3 gezeigt ist, sondern als diesbezüglich geschlossener massiver Block ausgebildet.

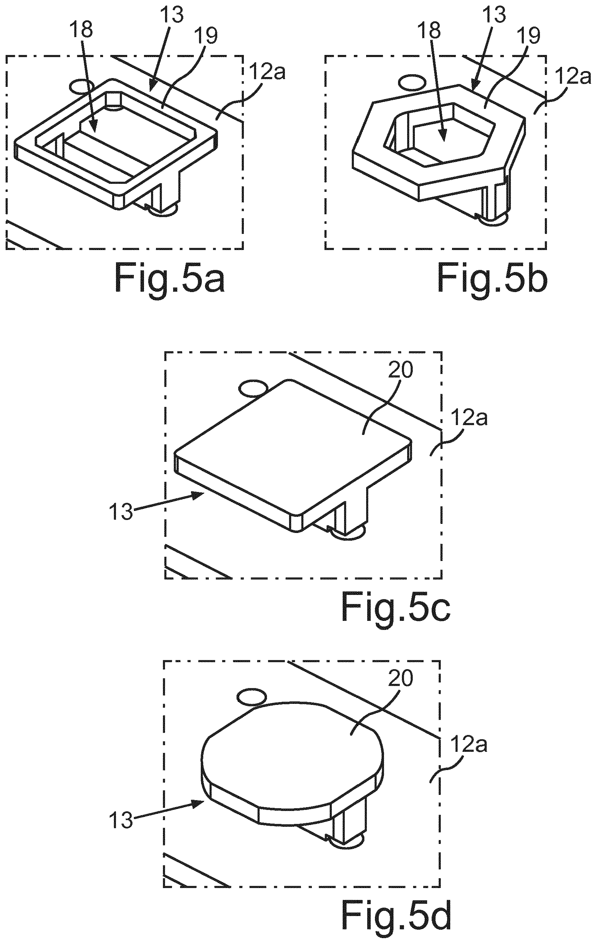

In Fig. 5a, 5b, 5c und 5d sind perspektivische Darstellungen von möglichen Ausgestaltungen des Gehäuses 13 gezeigt. In Fig. 5a ist eine Ausführungsform eines 1K-Kunststoffgehäuses gezeigt, welches auf dem der Leiterplatte 12 abgewandten oberen Ende einen umlaufenden Rahmen 19 aufweist, der hier viereckig ausgebildet ist.

In Fig. 5b hingegen ist eine Ausgestaltung gezeigt, bei der ebenfalls ein Rahmen 19 ausgebildet ist, der hier jedoch sechseckig gestaltet ist.

In Fig. 5c ist eine perspektivische Darstellung eines Gehäuses 13 gezeigt, wie es in Fig. 4 ausgebildet ist. Hier ist das Gehäuse 13 an seinem der Leiterplatte 12 abgewandten oberen Ende vollständig geschlossen und plattenartig gestaltet, sodass hier eine geschlossene Deckenwand 20, die vorzugsweise hier viereckig ausgebildet ist, realisiert ist.

In Fig. 5d ist eine alternative Ausgestaltung dazu gezeigt, bei welcher die Deckenwand 20 an den Eckbereichen abgerundet ausgebildet ist.

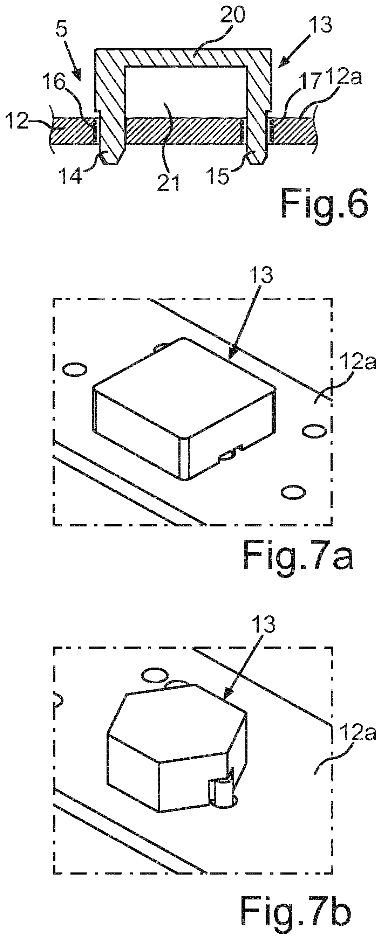

In Fig. 6 ist in einer weiteren Vertikalschnittdarstellung ein weiteres Ausführungsbeispiel einer Bedienvorrichtung 5 gezeigt, wobei hier auch bei dieser Ausführung das Gehäuse 13 als 1K-Kunststoffgehäuse ausgebildet ist.

Im Unterschied zu den Ausgestaltungen gemäß Fig. 3 und Fig. 4 ist das einstückige Gehäuse 13 hier nicht als massiver Block ausgebildet, der mit einem Zentralbereich vollflächig auf der Oberseite 12a der Leiterplatte 12 aufsitzt, sondern es sitzt hier nur der Rand auf. Durch das Gehäuse 13 und die Oberseite 12a ist dann ein Volumenraum 21 begrenzt. Bei dieser Ausgestaltung ist das Gehäuse 13 somit als Abdeckhaube und somit als Hohlkörper ausgebildet.

In Fig. 7a ist in einer perspektivischen Darstellung eine mögliche Formgestaltung des Gehäuses 13 gezeigt. Hier ist eine viereckige Form realisiert. Ebenso möglich ist es, dass gemäß der Darstellung in Fig. 7b dieses Gehäuse 13, wie es in Fig. 6 im Schnitt gezeigt ist, sechseckig ausgebildet ist.

Auch die Ausführungen gemäß Fig. 4 bis Fig. 7b zeigen kapazitive Sensortasten, die ohne Beleuchtung und somit ohne Leuchtsymbole ausgebildet sind. Es kann jedoch vorgesehen sein, dass das Bedienelement 6 und somit die kapazitive Sensortaste eine Beleuchtung aufweist und somit zumindest auch eine Lichtquelle umfasst.

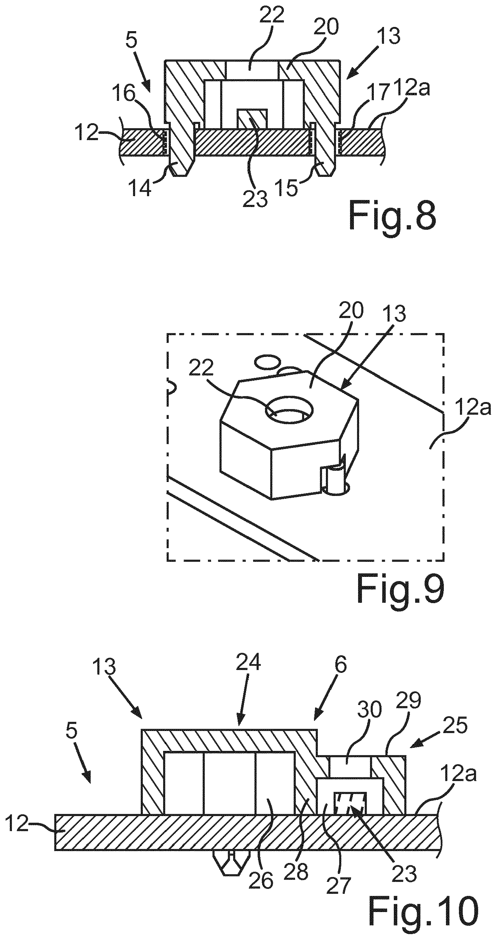

Dazu ist in Fig. 8 in einer Schnittdarstellung ein weiteres Ausführungsbeispiel einer Bedienvorrichtung 5 gezeigt. Diese Ausführungsform ist insbesondere geometrisch an die Ausgestaltung gemäß Fig. 6 angepasst, wobei im Unterschied dazu an einer Deckenwand 20 eine Durchbrechung 22 ausgebildet ist, durch welche Licht einer auf der Leiterplatte 12 angeordneten Lichtquelle 23 austreten kann.

In Fig. 9 ist eine perspektivische Darstellung der Ausführung gemäß Fig. 8 gezeigt. Beispielhaft ist hier das Gehäuse 13 entsprechend der Ausgestaltung in Fig. 7b realisiert und in der Deckenwand 20 die Durchbrechung 22 zu erkennen. Das Gehäuse 13 kann jedoch auch beispielsweise gemäß der Ausgestaltung in Fig. 7a realisiert sein und auch dort in der Deckenwand 20 eine entsprechende Durchbrechung 22 ausgebildet sein.

Ein besonders vorteilhaftes Ausführungsbeispiel ist in Fig. 10 gezeigt, wobei hier ebenfalls eine Vertikalschnittdarstellung gezeigt ist. Auch bei dieser Ausführungsform ist das Bedienelement 6 mit einer Beleuchtung bzw. Leuchtsymbolen ausgebildet.

Bei einer erfindungsgemäßen Ausgestaltung wie es in Fig. 10 gezeigt ist, weist das Bedienelement 6 ein Gehäuse 13 auf, welches einen Bediengehäusebereich 24 und zusätzlich einen Anzeigegehäusebereich 25 aufweist. Auch hier ist das Gehäuse 13 einstückig ausgebildet und kann vorzugsweise als 1K-Kunststoffgehäuse ausgebildet sein. Es ist zu erkennen, dass die beiden Gehäusebereiche 24 und 25 in horizontaler Richtung betrachtet nebeneinander ausgebildet sind und jeweils als haubenartige Komponenten gestaltet sind, so dass darunter Volumen 26 und 27 ausgebildet sind. Wie zu erkennen ist, weist das Gehäuse 13 eine Gehäusewand 28 auf, die sowohl Bestandteil des Bediengehäusebereichs 24 als auch des Anzeigegehäusebereichs 25 ist. Diese Gehäusewand 28 trennt die Volumen 26 und 27. Insbesondere ist diese Gehäusewand 28 auf der Oberseite 12a der Leiterplatte 12 aufsitzend. Die Gehäusebereiche 24 und 25 sind überlappungsfrei zueinander angeordnet und direkt aneinander angrenzend, wobei sie sich dazu insbesondere die Gehäusewand 28 teilen.

Wie zu erkennen ist, ist der Anzeigegehäusebereich 25 in vertikaler Richtung und somit in Höhenrichtung betrachtet niedriger als der Bediengehäusebereich 24. Auch in horizontaler Erstreckung ist dieser Anzeigegehäusebereich 25 kürzer bzw. kleiner ausgebildet, als der Bediengehäusebereich 24. In einer Deckenwand 29 des Anzeigegehäusebereichs 25 ist eine Durchbrechung 30 ausgebildet, durch welche das Licht der zumindest einen Lichtquelle 23 hindurchtreten kann. Die Durchbrechung 22 kann auch vorzugsweise durch ein lichtdurchlässiges Element verschlossen sein. Ebenso kann dies auch bei den Ausführungen gemäß Fig. 8 und Fig. 9 realisiert sein.

Durch diese örtliche Trennung der Bedienung einerseits und der optischen Anzeige andererseits kann das gleichzeitige Bedienen und Wahrnehmen von Lichtinformationen besonders zuverlässig und sicher erfolgen.

Es können allgemein rein Lichtinformationen angezeigt werden oder auch optische Symbole angezeigt werden.

Auch hier ist insbesondere das Gehäuse 13 als 1K-Kunststoffgehäuse ausgebildet und somit aus einem auch elektrisch leitfähigen Kunststoff gebildet.

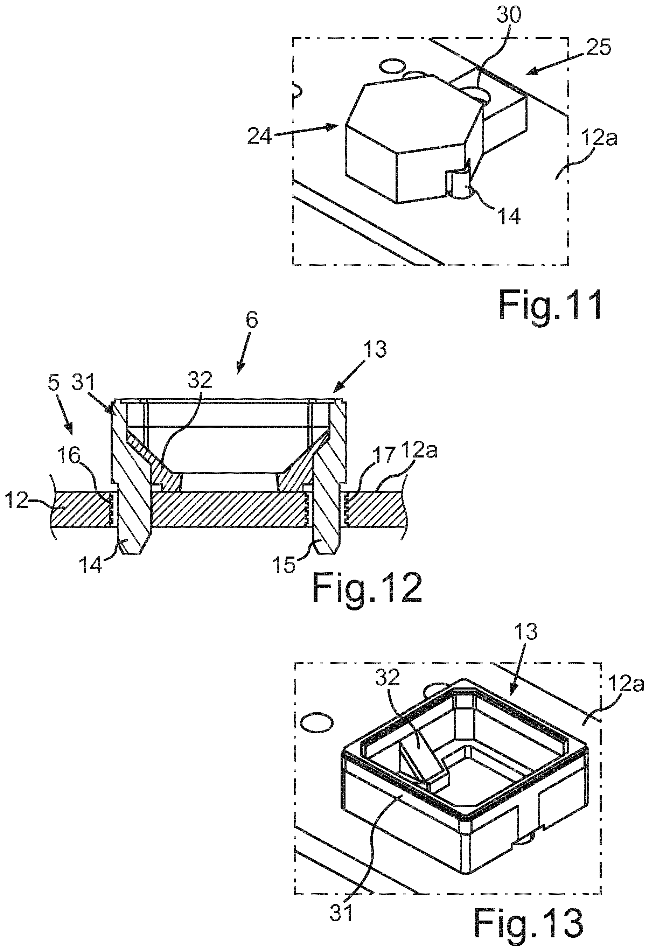

In Fig. 11 ist in einer perspektivischen Darstellung eine Ausführung des Gehäuses 13 gezeigt, wobei hier der Bediengehäusebereich 24 sechseckig ausgebildet ist und der Anzeigegehäusebereich 25 viereckig ausgebildet ist. Auch dies ist jedoch lediglich als beispielhafte Ausführung zu verstehen.

Insbesondere ist diese Bedienvorrichtung 5 unterhalb der Kochfeldplatte 7 bei der Ausführung des Haushaltsgeräts 1 als Kochfeld, wie es in Fig. 2 gezeigt ist, angeordnet. Bei einer derartigen Ausgestaltung kann der Bediengehäusebereich 24 dann auch auf der Oberseite der Kochfeldplatte 7 durch eine Bedruckung kenntlich gemacht werden, sodass ein Nutzer dann genau weiß, an welcher Stelle auf der Oberseite der Kochfeldplatte 2 er draufzudrücken hat bzw. eine Berührung vorzunehmen hat, um die kapazitive Sensortaste zu betätigen.

In Fig. 12 ist in einer Vertikalschnittdarstellung ein weiteres Ausführungsbeispiel einer Bedienvorrichtung 5 gezeigt. Bei dieser Ausgestaltung ist das Gehäuse 13 des Bedienelements 6 als 2K-Kunststoffgehäuse ausgebildet. Ein Außengehäusebereich 31 ist hier aus einem elektrisch leitfähigen Kunststoff ausgebildet und ein Einleger bzw. ein Innengehäusebereich 32 aus einem nicht elektrisch leitfähigem Kunststoff ausgebildet. Der Innengehäusebereich 32 ist, wie es in Fig. 12 gezeigt ist, zumindest bereichsweise trichterartig ausgebildet und erstreckt sich nur teilweise über die Höhe des Außengehäusebereichs 31. In dieser Ausführung gemäß Fig. 12, welche in Fig. 13 in einer perspektivischen Darstellung in einer beispielhaft viereckigen Geometrie des Gehäuses 13 gezeigt ist, ist dieses Bedienelement 6 ohne Beleuchtung und somit ohne Leuchtsymbole ausgebildet.

Gerade bei Ausführungen, bei denen die kapazitive Sensortaste mit einer Beleuchtung ausgebildet ist, ist es vorteilhaft, wenn die seitlichen Gehäusewände geschlossen sind und somit insbesondere bis zur Oberseite 12a der Leiterplatte 12 reichen, um einen unerwünschten seitlichen Lichtaustritt zu vermeiden.

Es sei an dieser Stelle nochmals betont, dass die vielfältigsten gezeigten erläuterten Geometrien der Gehäuse 13 lediglich beispielhaft und nicht abschließend zu verstehen sind. Es können auch vielfältigsten andere Geometrien, Formgebungen und Ausmaße realisiert sein.

Es kann auch vorgesehen sein, dass die Bedienvorrichtung 5 ein Bedienelement 6 aufweist, wie es oben erläutert wurde, und zusätzlich ein weiteres Bedienelement aufweist, welches eine kapazitive Sensortaste aufweist, die ein 3K-Kunststoffgehäuse aufweist.

Ein weiterer Vorteil der Ausgestaltung als maximal 2K-Kunststoffgehäuse ist auch darin zu sehen dass viele kleinere Strukturen der elektrisch leitfähigen Komponenten ausgeführt werden können, was funktionelle Vorteile bringt.

### Bezugszeichenliste

- 1: Haushaltsgerät
- 2: Kochfeldplatte
- 3: Garraum
- 4: Tür
- 5: Bedienvorrichtung
- 6: Bedienelement
- 7: Kochfeldplatte
- 8: Kochzonen
- 12: Leiterplatte
- 12a: Oberseite
- 13: Gehäuse
- 14: Kontaktstifte
- 16: Durchkontaktierungen
- 18: Mulde
- 19: Rahmen
- 20: Deckenwand
- 21: Volumenraum
- 22: Durchbrechung
- 23: Lichtquelle
- 24: Bediengehäusebereich
- 25: Anzeigegehäusebereich
- 26: Volumen
- 28: Gehäusewand
- 29: Deckenwand
- 30: Durchbrechung
- 31: Außengehäusebereich
- 32: Innengehäusebereich

## Patentansprüche

1. Bedienelement (6) für ein Haushaltsgerät (1), welches eine kapazitive Sensortaste ist, welche ein Gehäuse (13) aufweist, das zumindest bereichsweise aus einem elektrisch leitfähigen Kunststoff ausgebildet ist, wobei das Gehäuse (13) als 2K-Kunststoffgehäuse oder als 1K-Kunststoffgehäuse ausgebildet ist, sodass das Gehäuse (13) als Spritzbauteil ausgebildet ist und maximal aus zwei verschiedenen Kunststoffen gespritzt ist, und wobei das Gehäuse (13) einen Bediengehäusebereich (24) zum Bedienen mit einem Finger aufweist, und einen Anzeigegehäusebereich (25) zum optischen Anzeigen von Lichtinformationen aufweist, wobei der Bediengehäusebereich (24) und der Anzeigegehäusebereich (25) einstückig hergestellt sind, **dadurch gekennzeichnet, dass** der Bediengehäusebereich (24) und der Anzeigegehäusebereich (25) in horizontaler Richtung betrachtet nebeneinander ausgebildet und jeweils als haubenartige Komponenten gestaltet sind und direkt aneinander angrenzend ausgebildet sind, wobei eine Gehäusewand (28) Bestandteil des Bediengehäusebereichs (24) und des Anzeigegehäusebereichs (25) ist und die Gehäusebereiche (24, 25) durch diese Gehäusewand (28) voneinander räumlich getrennt sind, wobei jeweils durch die Gehäusebereiche (24, 25) umschlossene Volumen (26, 27) voneinander getrennt sind, wobei der Anzeigegehäusebereich (25) in vertikaler Richtung betrachtet niedriger als der Bediengehäusebereich (24) und in horizontaler Erstreckung kleiner ausgebildet ist als der Bediengehäusebereich (24), und wobei in einer Deckenwand (29) des Anzeigegehäusebereichs (25) eine Durchbrechung (30) ausgebildet ist, durch welche Licht zumindest einer Lichtquelle (23) hindurchtreten kann.

2. Bedienelement (6) nach Anspruch 1, **dadurch gekennzeichnet, dass** das Gehäuse (13) nicht elastisch ausgebildet ist.

3. Bedienelement (6) nach Anspruch 1 oder 2, **dadurch gekennzeichnet, dass** das Gehäuse (13) Kontaktstifte (14, 15) aufweist, die zum Hindurchführen in Durchkontaktierungen (16, 17) in einer Leiterplatte (12) ausgebildet sind, und welche aus dem elektrisch leitfähigen Kunststoff ausgebildet sind.

4. Bedienelement (6) nach einem der vorhergehenden Ansprüche, **dadurch gekennzeichnet, dass** bei einer Ausgestaltung als 2K-Kunststoffgehäuse das Gehäuse (13) bereichsweise aus dem elektrisch leitfähigen Kunststoff und bereichsweise aus einem elektrisch nicht leitfähigem Kunststoff ausgebildet ist.

5. Bedienvorrichtung (5) für ein Haushaltsgerät (1), mit zumindest einem Bedienelement (6) nach einem der vorhergehenden Ansprüche, und mit einer Leiterplatte (12), auf welcher das Bedienelement (6) angeordnet ist.

6. Bedienvorrichtung (5) nach Anspruch 5, **dadurch gekennzeichnet, dass** die den Bediengehäusebereich (24) und den Anzeigegehäusebereich (25) trennende Gehäusewand (28) des Gehäuses (13) auf der Leiterplatte (12) aufsitzend angeordnet ist.

7. Haushaltsgerät (1), insbesondere Gargerät, mit einer Bedienvorrichtung (5) nach Anspruch 5 oder 6.

## Claims

1. Operating element (6) for a household appliance (1), which is a capacitive touch key, which has a housing (13) which is embodied at least in areas from an electrically conductive plastic, wherein the housing (13) is embodied as a 2K plastic housing or as a 1K plastic housing so that the housing (13) is embodied as an injection-moulded part and is injection moulded at most from two different plastics, and wherein the housing (13) has an operating housing region (24) for operation with a finger, and a display housing region (25) for visually displaying light information, wherein the operating housing region (24) and the display housing region (25) are produced in one piece, **characterised in that** the operating housing region (24) and the display housing region (25) are embodied adjacent to one another when viewed in the horizontal direction and are in each case designed as cover-type components and are embodied adjoining one another directly, wherein a housing wall (28) is an integral part of the operating housing region (24) and the display housing region (25) and the housing regions (24, 25) are spatially separated from one another by means of this housing wall (28), wherein in each case volumes (26, 27) enclosed by the housing regions (24, 25) are separated from one another, wherein the display housing region (25), viewed in the vertical direction, is lower than the operating housing region (24) and is embodied smaller in the horizontal extension than the operating housing region (24), and wherein a through hole (30) is embodied in a cover wall (29) of the display housing region (25), through which through hole light from at least one light source (23) can pass.

2. Operating element (6) according to claim 1, **characterised in that** the housing (13) is not embodied to be elastic.

3. Operating element (6) according to claim 1 or 2, **characterised in that** the housing (13) has contact pins (14, 15), which are embodied to lead through into through-connections (16, 17) in a circuit board (12), and which are embodied from the electrically conductive plastic.

4. Operating element (6) according to one of the preceding claims, **characterised in that** with an embodiment as a 2K plastic housing, the housing (13) is embodied in regions from the electrically conductive plastic and in regions from an electrically nonconductive plastic.

5. Operating device (5) for a household appliance (1), having at least one operating element (6) according to one of the preceding claims, and with a circuit board (12), on which the operating element (6) is arranged.

6. Operating device (5) according to claim 5, **characterised in that** the housing wall (28) of the housing (13) which separates the operating housing region (24) and the display housing region (25) is arranged resting on the circuit board (12).

7. Household appliance (1), in particular cooking appliance, having an operating device (5) according to claim 5 or 6.

## Revendications

1. Élément de commande (6) pour un appareil électroménager (1), qui est une touche à effleurement capacitive, laquelle comprend un boîtier (13) formé au moins par endroits d'une matière plastique électriquement conductrice, dans lequel le boîtier (13) est réalisé sous forme d'un boîtier en matière plastique à deux composants ou sous forme d'un boîtier en matière plastique à un composant, de telle manière que le boîtier (13) est réalisé sous forme d'une pièce moulée par injection et qu'il est moulé par injection à partir de deux matières plastiques différentes au maximum, et dans lequel le boîtier (13) comprend une partie de boîtier de commande (24) permettant d'effectuer une commande avec un doigt, et comprend une partie de boîtier d'affichage (25) permettant un affichage optique d'informations lumineuses, la partie de boîtier de commande (24) et la partie de boîtier d'affichage (25) étant fabriquées d'une seule pièce,
**caractérisé en ce que** la partie de boîtier de commande (24) et la partie de boîtier d'affichage (25) sont formées l'une à côté de l'autre vu dans une direction horizontale et sont configurées respectivement sous forme de composants en forme de coiffe et sont construites de façon directement attenante l'une à l'autre, dans lequel une paroi de boîtier (28) fait partie intégrante de la partie de boîtier de commande (24) et de la partie de boîtier d'affichage (25) et les parties de boîtier (24, 25) sont séparées spatialement l'une de l'autre par cette paroi de boîtier (28), dans lequel des volumes (26, 27) confinés respectivement par les parties de boîtier (24, 25) sont séparés l'un de l'autre, dans lequel la partie de boîtier d'affichage (25) est formée de façon à être plus basse vu en direction verticale que la partie de boîtier de commande (24) et plus petite dans l'étendue horizontale que la partie de boîtier de commande (24), et une découpure (30) est formée dans une paroi supérieure (29) de la partie de boîtier d'affichage (25), à travers laquelle de la lumière d'au moins une source lumineuse (23) peut passer.

2. Élément de commande (6) selon la revendication 1, **caractérisé en ce que** le boîtier (13) est construit de façon non élastique.

3. Élément de commande (6) selon la revendication 1 ou 2, **caractérisé en ce que** le boîtier (13) comprend des broches de contact (14, 15) qui sont configurées pour permettre une transmission dans des trous métallisés (16, 17) dans une carte à circuit imprimé (12), et qui sont formées en la matière plastique électriquement conductrice.

4. Élément de commande (6) selon l'une des revendications précédentes, **caractérisé en ce que**, dans une configuration en forme de boîtier en matière plastique à deux composants, le boîtier (13) est formé par endroits d'une matière plastique électriquement conductrice et par endroits d'une matière plastique non électriquement conductrice.

5. Dispositif de commande (5) pour un appareil électroménager (1), comprenant au moins un élément de commande (6) selon l'une des revendications précédentes, et comprenant une plaque à circuit imprimé (12), sur laquelle l'élément de commande (6) est disposé.

6. Dispositif de commande (5) selon la revendication 5, **caractérisé en ce que** la paroi de boîtier (28) du boîtier (13) séparant la partie de boîtier de commande (24) et la partie de boîtier d'affichage (25) est agencée de façon à reposer sur la plaque à circuit imprimé (12).

7. Appareil électroménager (1), en particulier appareil de cuisson, comprenant un dispositif de commande (5) selon la revendication 5 ou 6.
